Europäisches Patentamt

**European Patent Office**

**Office européen des brevets**

(19)

(11) Numéro de publication: **0 093 086**
**A2**

(12)

# DEMANDE DE BREVET EUROPEEN

(21) Numéro de dépôt: **83810169.9**

(22) Date de dépôt: **22.04.83**

(51) Int. Cl.³: **H 01 L 27/06**

(30) Priorité: **23.04.82 CH 2474/82**

(43) Date de publication de la demande:
**02.11.83 Bulletin 83/44**

(84) Etats contractants désignés:
**DE FR GB IT NL SE**

(71) Demandeur: **CENTRE ELECTRONIQUE HORLOGER S.A.**
**Maladière 71**
**CH-2000 Neuchâtel 7(CH)**

(72) Inventeur: **Vittoz, Eric A.**
**Bois du Pâquier 15**
**CH-2053 Cernier(CH)**

(74) Mandataire: **Brulliard, Joel**
**c/o Centre Electronique Horloger S.A. Maladière 71**
**CH-2000 Neuchâtel 7(CH)**

(54) **Dispositif semiconducteur bipolaire et circuit MOS incorporant un tel dispositif.**

(57) L'invention concerne les circuits intégrés réalisables à l'aide d'une technologie MOS.

Le dispositif de l'invention comporte un transistor MOS réalisé dans un semiconducteur (11). L'invention consiste à polariser dans le sens direct la jonction formée par la région (14) et le semiconducteur (11) et à polariser la grille (G) de manière à empêcher tout phénomène d'inversion dans la zone de canal. Le transistor formé d'un émetteur (E), relié à la région (14), d'un collecteur (C), relié à la région (13) et d'une base (B), reliée au semiconducteur (11), a un comportement de transistor bipolaire. Le semiconducteur (11) peut être constitué par un caisson réalisé dans un substrat (10) de type opposé auquel cas le dispositif comporte une autre électrode (S) qui est soumise à une tension telle que la jonction caisson-substrat soit polarisée en inverse.

L'invention s'applique aux circuits intégrés en technologie MOS.

FIG.2.a

## DISPOSITIF SEMICONDUCTEUR BIPOLAIRE ET CIRCUIT MOS
## INCORPORANT UN TEL DISPOSITIF

La présente invention concerne un dispositif semiconducteur réalisable dans une technologie MOS et se rapporte plus particulièrement à un tel dispositif présentant une caractéristique de fonctionnement d'un transistor bipolaire ainsi qu'à des circuits MOS incorporant des transistors MOS associés audit dispositif à caractéristique de fonctionnement bipolaire.

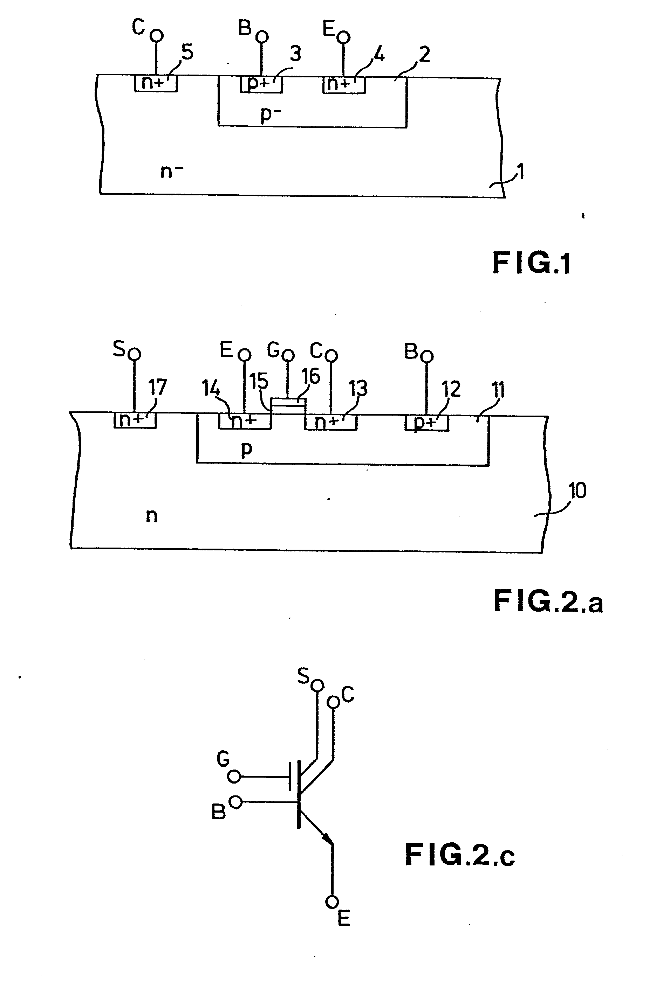

L'évolution actuelle des circuits électroniques intégrés montre un intérêt de plus en plus fort à la possibilité de réaliser sur le même circuit des fonctions analogiques et des fonctions numériques. Bien que les technologies bipolaires s'avèrent plus intéressantes pour les circuits purement analogiques, les technologies MOS gardent l'avantage lorsque la partie numérique du circuit est importante. Bien des tentatives ont été faites pour combiner les avantages des technologies bipolaires et MOS, mais ces tentatives soit impliquent des modifications des procédés de fabrication existants, soit résultent dans des dispositifs aux applications très limitées. A titre d'exemples de procédés modifiés pour permettre l'intégration de dispositifs bipolaires et MOS, on peut citer l'article de M. Darwish et R. Taubenest, intitulé "CMOS and complementary isolated bipolar transistor monolithic integration process" et paru dans Journal of the Electrochemical Society, Vol. 121, No 8, August 1974, ainsi que l'article de Otto H. Shade Jr intitulé "Bimos micropower IC's" paru dans IEEE Journal of Solid-State Circuits, Vol. SC-13, No 6, Dec. 1978. Les modifications de procédés consistent, en fait, en des étapes supplémentaires de fabrication; ce qui accroît les coûts et diminue les rendements des circuits. On a déjà proposé des dispositifs bipolaires réalisables avec une technologie MOS notamment dans les articles de Yannis P. Tsividis et al, intitulé "A CMOS voltage reference" et paru dans IEEE J. of Solid-State Circuits, Vol. SC-13, No 6, December 1978 et de Eric A. Vittoz et al, intitulé "A low-voltage CMOS band-gap reference" et paru dans la même revue Vol. SC-14, No 3, June 1979. Un dispositif, tel que décrit dans les revues précitées et souvent appelé "transistor MOS au substrat", est représenté à la figure 1. Dans un substrat 1 de type n est réalisé un caisson 2 de type p. Une zone 4 de diffusion $n^+$, dans le caisson, est reliée à une électrode E servant d'émetteur tandis que le caisson 2 est relié à une électrode de base B et le substrat à une électrode de collecteur C. Le transistor bipolaire ainsi formé a, par définition, son collecteur C au potentiel du substrat et ce dernier est relié à la tension positive de la source d'alimentation. On conçoit que les applications d'un tel dispositif soient limitées.

Ainsi un objet de la présente invention est un dispositif semiconducteur réalisable à l'aide d'une technologie MOS standard et présentant les caractéristiques d'un transistor bipolaire sans avoir les limitations des dispositifs connus.

Un autre objet de l'invention est un circuit intégré réalisable à l'aide d'une technologie MOS standard et comportant des transistors MOS associés à des dispositifs présentant les caractéristiques d'un transistor bipolaire.

Le dispositif semiconducteur selon la présente invention, apte à être réalisé à l'aide d'une technologie MOS et présentant un comportement de transistor bipolaire, présente à la surface d'un matériau semiconducteur d'un type de conductivité donné, au moins une première et une deuxième régions de types de conductivité opposés; lesdites première et deuxième régions étant séparées l'une de l'autre par une zone dudit matériau semiconducteur qui est recouverte par une grille conductrice, elle-même isolée dudit matériau semiconducteur par une couche isolante, et une troisième région du même type de conductivité que ledit matériau semiconducteur, lesdites première, deuxième et troisième régions étant connectées respectivement à une électrode d'émetteur, une électrode de collecteur et à une électrode de base; et est caractérisé en ce que ladite grille est polarisée de manière à empêcher toute inversion du type de conductivité en surface de ladite zone et en ce que la jonction, formée par ladite première région et ledit matériau semiconducteur, est polarisée dans le sens direct, le dispositif ainsi constitué et polarisé offrant les caractéristiques de fonctionnement d'un transistor bipolaire.

Selon une autre caractéristique, le dispositif semiconducteur de l'invention fait partie d'un circuit intégré MOS, apte à réaliser une fonction analogique, comportant

- dans un substrat semiconducteur d'un premier type de conductivité des régions d'un second type de conductivité constituant les sources et drains de transistors dudit second type de conductivité et au moins un caisson dudit second type de conductivité dans lequel sont formées des régions dudit premier type de conductivité constituant les sources et drains de transistors dudit premier type de conductivité;

- des électrodes de grille, disposées au-dessus des zones dudit substrat séparant lesdites régions d'un second type de conductivité et au-dessus des zones dudit caisson séparant lesdites régions d'un premier type de conductivité, de manière à former des transistors à effet de champ et à grille isolée; ledit circuit étant caractérisé en ce qu'au moins l'une des sources des transistors est polarisée de manière à rendre conductrice la jonction formée par cette source et par le substrat ou le caisson dans lequel ladite source est formée et en ce que la grille du transistor correspondant est polarisée de manière à empêcher toute inversion du type de conductivité dans la zone de canal dudit transistor correspondant, ledit transistor correspondant offrant alors les caractéristiques d'un transistor bipolaire dont l'émetteur est constitué par ladite source et dont le collecteur et la base sont constitués respectivement par le drain et le substrat ou le caisson dudit transistor correspondant.

D'autres objets, caractéristiques et avantages de la présente invention apparaîtront plus clairement à la lecture de la description suivante d'exemples de réalisation particuliers, ladite description étant faite à titre purement illustratif et en relation avec les dessins joints dans lesquels:

- la figure 1 est une vue schématique d'un dispositif connu;

- la figure 2.a montre, en coupe, un dispositif à comportement bipolaire en accord avec les principes de la présente invention;

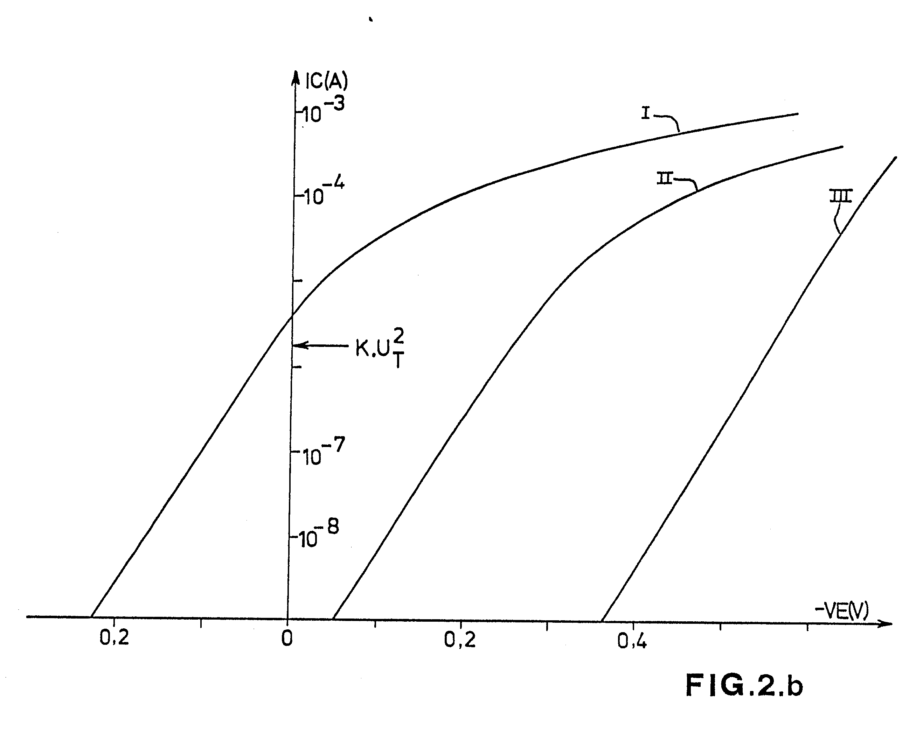

- la figure 2.b représente, en fonction de la polarisation de la grille, l'évolution des caractéristiques du dispositif de la figure 2.a;

- la figure 2.c montre le symbole utilisé pour la représentation du dispositif de l'invention;

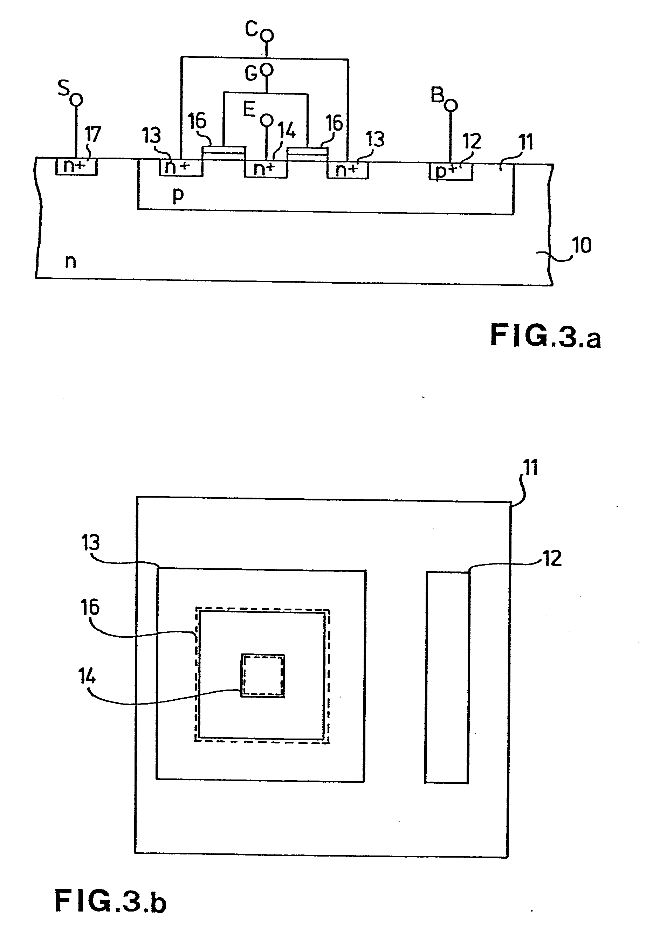

- la figure 3.a montre, en coupe, une autre variante du dispositif de l'invention;

- la figure 3.b montre le plan de masque correspondant au schéma de la figure 3.a;

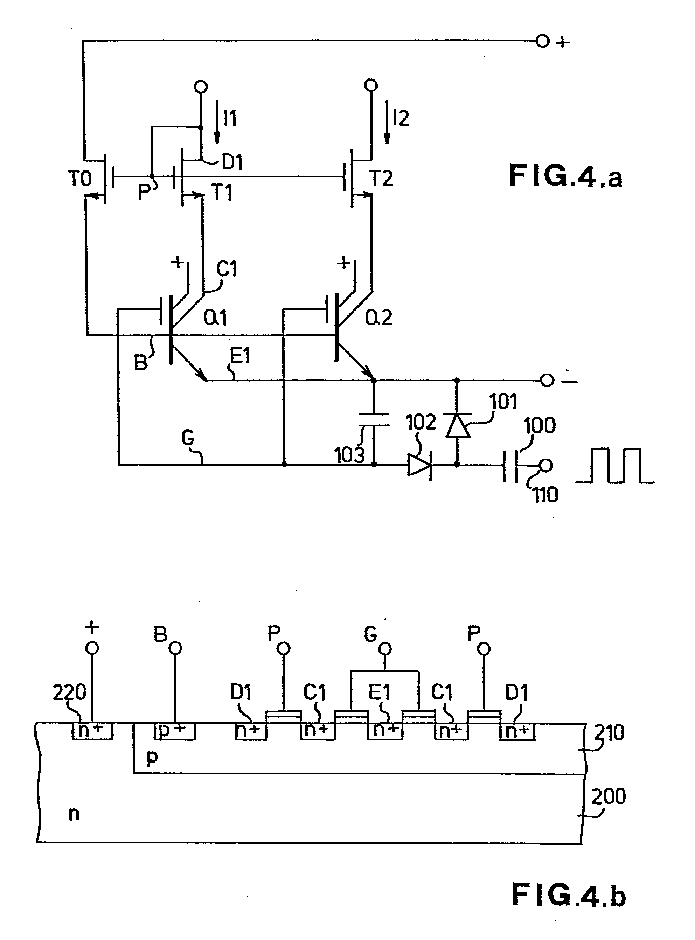

- la figure 4.a montre un circuit miroir de courant utilisant le dispositif de l'invention;

- la figure 4.b montre, en coupe, un exemple d'implantation d'une partie du circuit de la figure 4.a;

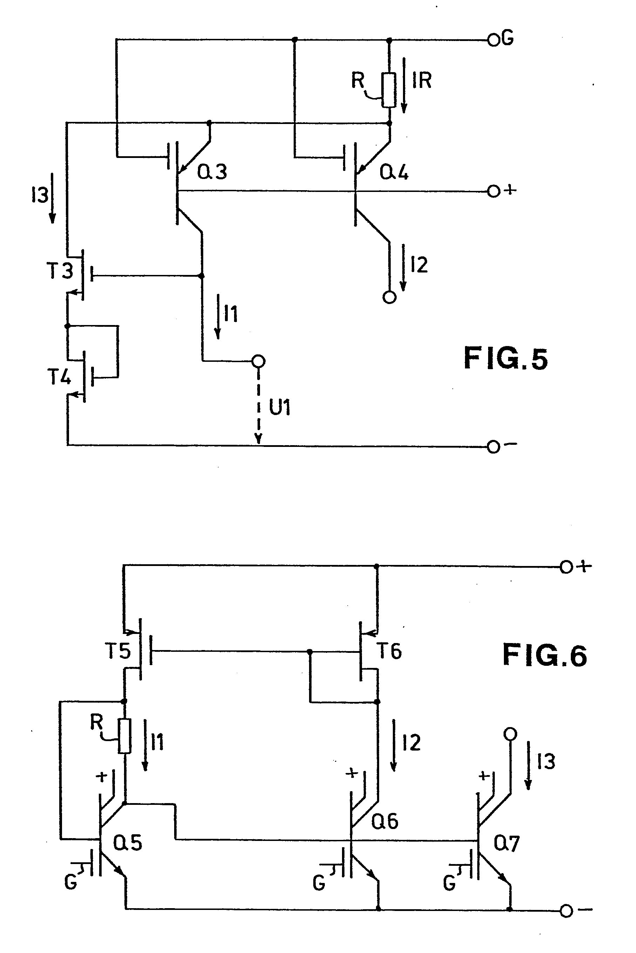

- la figure 5 montre un autre circuit miroir de courant;

- la figure 6 montre une source de courant utilisant le dispositif de l'invention;

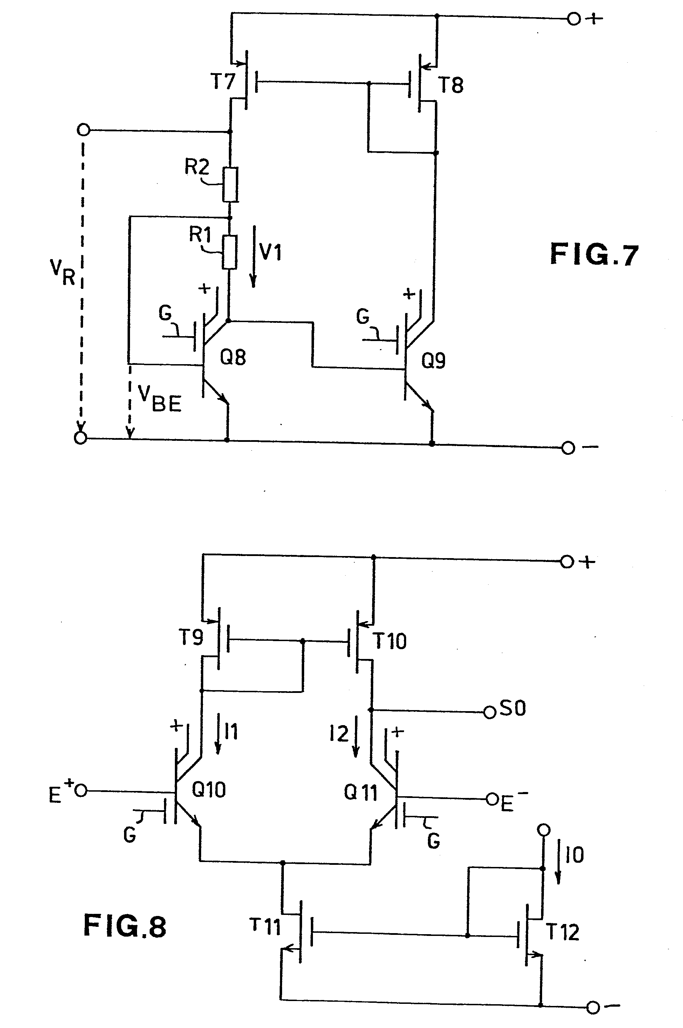

- la figure 7 montre un circuit de référence de tension utilisant le dispositif de l'invention; et

- la figure 8 montre un amplificateur différentiel.

La figure 2.a montre le dispositif de l'invention, réalisable à l'aide d'une technologie MOS standard et présentant des caractéristiques de transistor bipolaire lorsqu'il est polarisé de manière convenable. Dans un substrat 10 de type n est réalisé, par exemple au moyen d'une diffusion, un caisson 11 de type p. Le caisson 11 est relié, par l'intermédiaire d'une diffusion de type $p^+$, à une électrode de base B, tandis que deux diffusions de type $n^+$ sont reliées l'une 14 à une électrode d'émetteur E et l'autre 13 à une électrode de collecteur C. Une grille 16, en métal ou en silicium polycristallin dopé, est déposée sur un oxyde isolant 15 au-dessus de l'espace entre les deux diffusions 13 et 14; elle est reliée à une électrode de grille G. Le substrat 10 est relié à une électrode S par l'intermédiaire d'une diffusion 17 de type $n^+$. La structure de l'invention diffère de celle de l'art antérieur (figure 1) par la présence d'une grille 16. Selon l'invention, l'électrode de grille G est portée à un potentiel suffisamment négatif, pour éviter l'inversion du type de conductivité de la zone située entre les diffusions 13 et 14, et la jonction p-n, caisson 11-substrat 10, est polarisée dans le sens inverse. Lorsque la jonction d'émetteur $n^+$-p est polarisée dans le sens direct, des électrons sont émis dans le caisson 11 (relié à l'électrode de base B), dont une partie est collectée par le collecteur C (la jonction de collecteur $n^+$-p étant polarisée en inverse). On peut alors définir, pour ce transistor bipolaire, un gain en courant $\alpha_C = -\dfrac{I_C}{I_E}$ ; où $I_E$ et $I_C$ représentent les courants d'émetteur et de collecteur respectivement et un gain en courant $\alpha_S = -\dfrac{I_S}{I_E}$; où $I_S$ représente le courant collecté par le substrat 10. On aura toujours $\alpha_C + \alpha_S < 1$. Par contre, comme il sera vu plus loin, les gains en courant $\beta = \dfrac{I_C}{I_B}$ et $\beta_S = \dfrac{I_S}{I_B}$ peuvent atteindre des valeurs assez grandes ce qui rend le dispositif de l'invention parfaitement utilisable en pratique.

La figure 2.b représente les variations du courant de collecteur $I_C$ en fonction du potentiel appliqué à l'émetteur E pour différentes valeurs de la tension de grille $V_G$. Tous les potentiels étant définis par rapport au caisson 11, le collecteur est maintenu à une tension fixe de 2 volts et l'électrode S est soumise à une tension positive de manière à bloquer la jonction caisson-substrat. Lorsque la grille est à une tension positive (courbe I, $V_G$ = 0.5 volt), le dispositif se comporte comme un transistor MOS. Lorsque la tension de grille est nulle (courbe II, $V_G$ = 0 volt), la même loi de variation est obtenue pour des valeurs négatives du potentiel d'émetteur. Par contre, lorsque la grille est portée à un potentiel fortement négatif inférieur à -1.2 volt (courbe III, $V_G$ = -1.5 volt), la relation entre le courant de collecteur $I_C$ et la tension d'émetteur $-V_E$ devient indépendante de la tension de grille $V_G$ et cette relation reste de nature exponentielle même pour des valeurs élevées du courant alors que pour le transistor MOS (courbes I et II), elle n'est exponentielle que pour des valeurs du courant inférieures à $K.U_T^2$, (où K est un facteur dépendant de la géométrie du transistor et de la technologie utilisée et $U_T = k.T/q$ est la tension thermodynamique proportionnelle à la température absolue). La valeur de courant $K.U_T^2$ définit, pour un transistor MOS, la limite de fonctionnement entre le régime en faible inversion et le régime en forte inversion. On voit donc que lorsque la tension de grille est suffisamment négative, le dispositif de la figure 2.a se comporte comme un transistor bipolaire.

Les figures 3.a et 3.b montrent une variante du dispositif précédent dans laquelle la diffusion de collecteur 13 entoure complètement la diffusion d'émetteur 14. La figure 3.b montre la disposition de la grille 16 et des diffusions 12, 13 et 14 réalisées dans le caisson 11. Un tel arrangement permet d'avantager le transistor bipolaire latéral au détriment du transistor au substrat et d'obtenir des valeurs typiques du gain en courant $\beta$ de l'ordre de 50 avec un courant d'émetteur $I_E$ de 1 μA.

L'obtention d'un gain aussi élevé montre la possibilité d'utiliser de telles structures en combinaison avec des transistors MOS notamment pour des applications analogiques. Les structures bipolaires offrent l'avantage, outre d'une caractéristique exponentielle du courant d'émetteur en fonction de la tension émetteur-base, d'un meilleur appariement, d'une meilleure reproductibilité et d'une plus faible composante de bruit en basse fréquence que les structures MOS.

Les figures suivantes montrent plusieurs exemples de circuits, réalisables en technologie CMOS, incorporant des transistors MOS et des transistors bipolaires selon la présente invention. La figure 4.a représente un miroir de courant où I1 est le courant d'entrée et I2 le courant de sortie. Les transistors T0, T1 et T2 sont des transistors MOS à canal n tandis que Q1 et Q2 sont des transistors bipolaires selon l'invention, le symbole utilisé étant représenté à la figure 2.c. Le transistor MOS T0 fournit le courant de base des transistors Q1 et Q2. Ces derniers sont connectés chacun en série avec un transistor MOS, soit T1 et T2 en série avec Q1 et Q2 respectivement. Les émetteurs de Q1 et Q2 sont reliés à la borne négative de la source d'alimentation. Le drain de T0 ainsi que le substrat dans lequel le circuit est réalisé sont reliés à la borne positive de la source d'alimentation. Les grilles de Q1 et Q2 sont polarisées négativement par rapport à l'émetteur grâce au circuit de "clampage" constitué par les diodes 101 et 102 et les capacités 100 et 103 et alimenté par un signal carré appliqué sur la borne 110. Si les transistors T1 et T2 d'une part, Q1 et Q2 d'autre part, sont identiques le courant de sortie I2 est égal au courant d'entrée I1. La figure 4.b montre l'implantation possible des transistors T1 et Q1 du circuit de la figure 4.a. Le substrat 200 de type n est relié à la borne positive de l'alimentation par l'intermédiaire d'une diffusion de type n$^+$. Dans le caisson 210 de type p, le transistor Q1 est réalisé avec une structure concentrique de même que le transistor T1. Le caisson sert d'électrode de base pour le transistor Q1. Les transistors T2 et Q2, de même que d'autres couples de transistors Ti et Qi, peuvent être réalisés de la même façon dans le caisson 210. La symétrie mesurée, à savoir l'égalité des courants I1 et I2, d'un tel miroir de courant est quatre à cinq fois meilleure que celle d'un circuit équivalent travaillant avec le même courant d'entrée I1 et n'utilisant que des transistors MOS.

La figure 5 montre un autre miroir de courant dans lequel les transistors bipolaires sont réalisés directement dans le substrat de type n; ces transistors bipolaires étant du type p-n-p. Les électrodes de grille G de Q3 et Q4 sont portées à un potentiel plus positif que celui du substrat (base de Q3 et Q4) soit à l'aide d'une source extérieure au circuit, soit en utilisant un circuit de "clampage" semblable à celui de la figure 4.a. Ce potentiel appliqué en G sert à produire un courant $I_R$ à travers la résistance R. Ce courant $I_R$ est égal à la somme du courant $I_3$, produit par T3 et T4, et des courants d'émetteur de Q3 et Q4. Si l'on applique une tension $U_1$ entre le collecteur de Q3 et la borne d'alimentation négative du circuit et si les transistors Q3 et Q4 sont identiques, on obtient sur le collecteur de Q4 un courant de sortie I2 égal au courant de collecteur I1 de Q3.

La figure 6 montre un circuit, pouvant servir de source de courant, qui tire avantage du bon appariement et de la caractéristique exponentielle des transistors bipolaires. En négligeant les courants de base des transistors Q5 à Q7, les courants de collecteur I1 et I2 des transistors Q5 et Q6 respectivement sont liés par la relation

$$\frac{I_2}{I_1} = K' \, e^{\frac{-V}{U_T}} \; ;$$

où K' est le rapport des surfaces de Q6 et Q5, V est égal à R. I1 et $U_T$ est la tension thermodynamique $k \cdot \frac{T}{q}$. Si les transistors T5 et T6 sont identiques, le miroir qu'ils forment impose $\frac{I_2}{I_1} = 1$; ce qui en-entraîne $I_2 = \frac{U_T}{R}$ ln K'. Le transistor Q7 permet d'extraire un courant I3 proportionnel à I2. Comme précédemment, les grilles G des transistors bipolaires Q5 à Q7 sont polarisées par une tension plus négative que la tension d'émetteur et le substrat est porté au potentiel le plus positif du circuit.

La figure 7 montre une variante du circuit de la figure 6, capable de fournir une tension de référence $V_R$ indépendante de la température. Comme dans le cas de la figure 6, si V1 représente la tension aux bornes de la résistance R1 et si les transistors MOS T7 et T8 sont identiques, on a la relation: $V_1 = U_T \cdot$ ln K", dans laquelle K" représente le rapport des surfaces des transistors bipolaires Q9 et Q8. On en déduit: $V_R = \frac{R_2}{R_1} U_T \cdot$ ln K" $+ V_{BE}$, dans laquelle $V_{BE}$ est la tension base-émetteur de Q8. Cette tension $V_{BE}$ est une fonction linéairement décroissante de la température absolue. Il est donc possible, par un choix judicieux de la valeur du rapport $R_2/R_1$, de rendre la tension $V_R$ indépendante de la température.

La figure 8 montre un schéma d'amplificateur différentiel tirant partie du faible bruit et du bon appariement des transistors bipolaires selon l'invention. Le schéma de principe de cet amplificateur est bien connu. Les deux transistors bipolaires Q10 et Q11 sont polarisés par le miroir de courant formé par les transistors MOS T11 et T12 et alimenté par un courant de polarisation IO. Les deux transistors MOS T9 et T10, également arrangés en miroir de courant, constituent une charge pour les transistors Q10 et Q11. Si le potentiel des entrées $E^+$ et $E^-$ de l'amplificateur différentiel est suffisamment élevé, la grille G des transistors Q10 et Q11 peut être reliée directement à la borne d'alimentation négative du circuit, ce qui élimine la nécessité d'une source d'alimentation supplémentaire. La borne SO constitue la sortie de cet amplificateur différentiel.

Bien que l'invention ait été décrite dans le cadre d'une technologie utilisant un substrat de type n et plus particulièrement d'une technologie CMOS, elle n'est nullement limitée aux exemples d'application décrits. Il est clair, en effet, que l'invention est encore applicable dans le cas d'une technologie MOS basée sur l'utilisation d'un substrat de type p et de caissons de type n.

REVENDICATIONS

1. Dispositif semiconducteur, apte à être réalisé à l'aide d'une technologie MOS et présentant un comportement de transistor bipolaire, ledit dispositif présentant, à la surface d'un matériau semiconducteur d'un type de conductivité donné, au moins une première et une deuxième régions d'un type de conductivité opposé, lesdites première et deuxième régions étant séparées l'une de l'autre par une zone dudit matériau semiconducteur qui est recouverte par une grille conductrice, elle-même isolée dudit matériau semiconducteur par une couche isolante, et une troisième région du même type de conductivité que ledit matériau semiconducteur, lesdites première, deuxième et troisième régions étant connectées respectivement à une électrode d'émetteur, une électrode de collecteur et à une électrode de base; ledit dispositif étant caractérisé en ce que ladite grille est polarisée de manière à empêcher toute inversion du type de conductivité en surface de ladite zone et en ce que la jonction, formée par ladite première région et ledit matériau semiconducteur, est polarisée dans le sens direct, le dispositif ainsi constitué et polarisé offrant les caractéristiques de fonctionnement d'un transistor bipolaire.

2. Dispositif semiconducteur selon la revendication 1, caractérisé en ce qu'il comporte n régions identiques à ladite deuxième région, lesdites n régions et ladite deuxième région étant reliées à autant d'électrodes de collecteur.

3. Dispositif semiconducteur selon la revendication 1, caractérisé en ce que ledit matériau semiconducteur est constitué par un caisson réalisé dans un substrat semiconducteur d'un type de conductivité opposé à celui dudit caisson et en ce que la jonction formée par le caisson et le substrat est polarisée dans le sens inverse.

4. Dispositif semiconducteur selon la revendication 1 ou la revendication 3, caractérisé en ce que ladite deuxième région entoure complètement ladite première région.

5. Circuit intégré MOS, apte à réaliser une fonction analogique, comportant

- dans un substrat semiconducteur d'un premier type de conductivité des régions d'un second type de conductivité constituant les sources et drains de transistors dudit second type de conductivité et au moins un caisson dudit second type de conductivité dans lequel sont formées des régions dudit premier type de conductivité constituant les sources et drains de transistors dudit premier type de conductivité;

- des électrodes de grille, disposées au-dessus des zones dudit substrat séparant lesdites régions d'un second type de conductivité et au-dessus des zones dudit caisson séparant lesdites régions d'un premier type de conductivité, de manière à former des transistors à effet de champ et à grille isolée; ledit circuit étant caractérisé en ce qu'au moins l'une des sources des transistors est polarisée de manière à rendre conductrice la jonction formée par cette source et par le substrat ou le caisson dans lequel ladite source est formée et en ce que la grille du transistor correspondant est polarisée de manière à empêcher toute inversion du type de conductivité dans la zone de canal dudit transistor correspondant, ledit transistor correspondant offrant alors les caractéristiques d'un transistor bipolaire dont l'émetteur est constitué par ladite source et dont le collecteur et la base sont constitués respectivement par le drain et le substrat ou le caisson dudit transistor correspondant.

6. Circuit intégré MOS selon la revendication 5, caractérisé en ce que la région constituant le collecteur du transistor bipolaire est prévue de manière à entourer complètement la région constituant son émetteur.

7. Circuit intégré MOS selon la revendication 5 ou la revendication 6, caractérisé en ce que le drain d'au moins un transistor dudit premier type de conductivité dans ledit caisson est relié au drain d'au moins un transistor dudit second type de conductivité dans ledit substrat, de manière à constituer un inverseur de type complémentaire.

8. Circuit intégré MOS selon l'une quelconque des revendications 5 à 7, caractérisé en ce que ledit substrat est de type N et ledit caisson est de type P.

0093086

FIG.1

FIG.2.a

FIG.2.c

FIG.2.b

0093086

FIG.3.a

FIG.3.b

**FIG.4.a**

**FIG.4.b**

0093086

FIG.5

FIG.6

0093086

FIG.7

$V_R$

$V_{BE}$

T7  T8

R2

R1  V1

G  Q8  G  Q9

+  +

+  −

FIG.8

T9  T10

I1  I2

+  +

E⁺  Q10  Q11  E⁻

G  G

S0

T11  T12

I0

+  −